# EUROPEAN PATENT APPLICATION

(11) **EP 4 708 620 A1**
(43) Date of publication of application: **11.03.2026**
(21) Application number: 25794812.5
(22) Date of filing: 18.02.2025
(51) Int. Cl.: H02J 7/00, G01R 19/165, G01R 31/382, H01M 10/44

(54) **APPARATUS AND METHOD FOR CONTROLLING BATTERY**

(30) Priority: 24.04.2024 KR 20240054522
(71) Applicant: LG Energy Solution, Ltd., Seoul 07335 (KR)
(72) Inventor: OH, Seung Take, Daejeon 34122 (KR)
(74) Representative: BCKIP Part mbB
(86) International application number: PCT/KR2025/099425
(87) International publication number: WO 2025/226125

(57) **Abstract**

A battery control device according to an embodiment of the present invention is located in a battery system including a plurality of batteries, and may include: at least one processor; and a memory that stores at least one command executed through the at least one processor. The at least one command may comprise: a command for monitoring the voltage of each of the batteries in a process in which the batteries are connected in parallel to a DC link and charged; a command for sequentially dropping, from the DC link, batteries that have reached a predefined target voltage; and a command for stopping a charging process in a state in which the N batteries are connected to the DC link when only N preset batteries remain connected to the DC link.

## Description

### [Technical Field]

This application claims priority to and the benefit of Korean Patent Application No.10-2024-0054522 filed in the Korean Intellectual Property Office on April 24, 2024 the entire contents of which are incorporated herein by reference.

The present invention relates to an apparatus and method for controlling battery, and more particularly, to an apparatus and method for controlling battery applicable to a battery system including a battery with a voltage plateau section.

### [Background Art]

Secondary batteries, capable of recharging and reuse, may be used as an energy source for small devices such as mobile phones, tablet PCs and vacuum cleaners, and also used as an energy source for medium and large devices such as automobiles and an energy storage system (ESS) for smart grids.

Secondary batteries may be applied to a system in a form of an assembly such as a battery module in which a plurality of battery cells is connected in series and parallel or a battery rack in which battery modules are connected in series and parallel according to system requirements. For medium and large-sized devices such as an energy storage system (ESS) for smart grids, a high-capacity battery system with multiple battery racks connected in parallel may be applied to satisfy required capacity of the device.

Carbon materials are mainly used as an anode active material of lithium secondary batteries, and lithium-containing cobalt oxide (LiCoO2) is mainly used as a cathode active material. In addition, lithium-containing manganese oxides (LiMnO2, LiMn2O4, etc.) and lithium-containing nickel oxide (LiNiO2) are also being considered. Recently, a lithium iron phosphate (LiFePO4)-based compound has been used as a cathode active material for a lithium secondary battery. A lithium iron phosphate (LFP) battery using lithium iron phosphate as a cathode active material is superior in terms of thermal stability and cost efficiency compared to other types of batteries.

However, the LFP battery shows a flat characteristic with a voltage plateau in a charge characteristic curve (a relationship curve between open circuit voltage and SOC), and a problem arises due to this that SOC (State of Charge) cannot be accurately estimated with the open circuit voltage in the plateau section. Accordingly, a battery system using LFP batteries should periodically perform a process of charging battery racks to a voltage range where SOC estimation is possible and then correcting the SOC.

However, when battery racks are reconnected in parallel to the DC link after this SOC correction process is completed, an inrush current may occur in the battery system due to the characteristics of LFP batteries that experience a rapid voltage drop.

Among the related art documents relevant to the present invention, KR 10-2361334 is of some relevance.

### [Detailed Description of the Invention]

### [Technical Problem]

To obviate one or more problems of the related art, embodiments of the present disclosure provide a battery control apparatus for preventing occurrence of inrush current in a battery system.

To obviate one or more problems of the related art, embodiments of the present disclosure also provide a battery control method performed by the battery control apparatus.

### [Technical Solution]

In order to achieve the objective of the present disclosure, a battery management apparatus may include at least one processor, and a memory configured to store at least one instruction executed by the at least one processor.

Here, the at least one instruction may include an instruction to monitor a voltage of each of the batteries while the batteries are connected in parallel to a direct current (DC) link and are being charged, an instruction to sequentially disconnect at least one battery that has reached a predefined target voltage from the DC link, and an instruction to, if only a predetermined number of batteries remain connected to the DC link, stop a charge process in a state that the predetermined number of batteries are connected to the DC link.

The instruction to monitor the voltage of each of the batteries may include an instruction to determine whether a maximum voltage value among voltage values of unit cells included in a battery reaches the target voltage.

The instruction to sequentially disconnect the at least one battery that has reached the predefined target voltage from the DC link may include an instruction to transmit a switch control signal for causing a switch connecting a battery and the DC link to be switched to an open state to a battery management apparatus of the at least one battery that has reached the predefined target voltage.

The instruction to stop the charge process may include an instruction to, when only one battery remains connected to the DC link and the one battery reaches the target voltage, stop the charge process in a state that the one battery is connected to the DC link.

The at least one instruction may further include an instruction to correct state of charges (SOCs) of one or more batteries disconnected from the DC link and one or more batteries connected to the DC link after the charge process is stopped.

The at least one instruction may further include an instruction to, upon the battery system switching to a standby mode after the charge process is stopped, collectively reconnecting one or more batteries that have been disconnected from the DC link to the DC link when a state of charge (SOC) of the batteries connected to the DC link reaches a predetermined SOC.

The at least one instruction may further include an instruction to, upon the battery system switching to a discharge mode after the charge process is stopped, sequentially reconnecting at least one battery, to the DC link, of which a voltage difference to at least one battery connected to the DC link becomes within a predetermined range in a process during which the at least one battery connected to the DC link is being discharged, among batteries that have been disconnected from the DC link.

According to another embodiment of the present disclosure, a battery control method, performed by battery control apparatus located in a battery system including a plurality of batteries, may include monitoring a voltage of each of the batteries while the batteries are connected in parallel to a direct current (DC) link and are being charged, sequentially disconnecting at least one battery that has reached a predefined target voltage from the DC link, and if only a predetermined number of batteries remain connected to the DC link, stopping a charge process in a state that the predetermined number of batteries are connected to the DC link.

The monitoring the voltage of each of the batteries may include determining whether a maximum voltage value among voltage values of unit cells included in a battery reaches the target voltage.

The sequentially disconnecting the at least one battery that has reached the predefined target voltage from the DC link may include transmitting a switch control signal for causing a switch connecting a battery and the DC link to be switched to an open state to a battery management apparatus of the at least one battery that has reached the predefined target voltage.

The stopping the charge process may include when only one battery remains connected to the DC link and the one battery reaches the target voltage, stopping the charge process in a state that the one battery is connected to the DC link.

The battery control method may further include correcting state of charges (SOCs) of one or more batteries disconnected from the DC link and one or more batteries connected to the DC link after the charge process is stopped.

The battery control method may further include, upon the battery system switching to a standby mode after the charge process is stopped, collectively reconnecting one or more batteries that have been disconnected from the DC link to the DC link when a state of charge (SOC) of the batteries connected to the DC link reaches a predetermined SOC.

The battery control method may further include, upon the battery system switching to a discharge mode after the charge process is stopped, sequentially reconnecting the at least one battery, to the DC link, of which a voltage difference to at least one battery connected to the DC link becomes within a predetermined range in a process during which the at least one battery connected to the DC link is being discharged, among batteries that have been disconnected from the DC link.

### [Advantageous Effects]

According to the embodiments of the present invention as described above, it is possible to prevent inrush current from occurring in a battery system.

### [Brief Description of the Drawings]

FIG. 1 is a block diagram of a general energy storage system.
FIG. 2 shows a charge characteristic curve of an LFP battery.
FIG. 3 is a graph for explaining a general battery control method.
FIG. 4 is a block diagram of a battery system according to embodiments of the present invention.
FIG. 5 is an operational flowchart of a battery control method in a charge mode according to embodiments of the present invention.
FIGS. 6 is a reference diagram for explaining a battery control method in a charge mode according to embodiments of the present invention.
FIG. 7 is an operational flowchart of a battery control method in a standby mode according to embodiments of the present invention.
FIG. 8 is a reference diagram for explaining a battery control method in a standby mode according to embodiments of the present invention.
FIG. 9 is an operational flowchart of a battery control method in a discharge mode according to embodiments of the present invention.
FIG. 10 is a reference diagram for explaining a battery control method in a discharge mode according to embodiments of the present invention.
FIG. 11 is a block diagram of a battery control apparatus according to embodiments of the present invention.

100 : battery
200: battery management apparatus
300, 1100: battery control apparatus

### [Best Modes for Practicing the Disclosure]

The present invention may be modified in various forms and have various embodiments, and specific embodiments thereof are shown by way of example in the drawings and will be described in detail below. It should be understood, however, that there is no intent to limit the present invention to the specific embodiments, but on the contrary, the present invention is to cover all modifications, equivalents, and alternatives falling within the spirit and technical scope of the present invention. Like reference numerals refer to like elements throughout the description of the figures.

It will be understood that, although the terms such as first, second, A, B, and the like may be used herein to describe various elements, these elements should not be limited by these terms. These terms are only used to distinguish one element from another. For example, a first element could be termed a second element, and, similarly, a second element could be termed a first element, without departing from the scope of the present invention. As used herein, the term "and/or" includes combinations of a plurality of associated listed items or any of the plurality of associated listed items.

It will be understood that when an element is referred to as being "coupled" or "connected" to another element, it can be directly coupled or connected to the other element or an intervening element may be present. In contrast, when an element is referred to as being "directly coupled" or "directly connected" to another element, there is no intervening element present.

The terms used herein is for the purpose of describing specific embodiments only and are not intended to limit the present invention. As used herein, the singular forms "a", "an" and "the" are intended to include the plural forms as well, unless the context clearly indicates otherwise. It will be further understood that the terms "comprises", "comprising", "includes", "including" and/or "having", when used herein, specify the presence of stated features, integers, steps, operations, constitutional elements, components and/or combinations thereof, but do not preclude the presence or addition of one or more other features, integers, steps, operations, constitutional elements, components, and/or combinations thereof.

Unless otherwise defined, all terms used herein, including technical and scientific terms, have the same meanings as commonly understood by one skilled in the art to which the present invention belongs. It will be further understood that terms, such as those defined in commonly used dictionaries, should be interpreted as having meanings that are consistent with their meanings in the context of the relevant art and will not be interpreted in an idealized or overly formal sense unless expressly so defined herein.

Some terms used herein are defined as follows.

A battery cell is a basic unit that serves to store power and a battery module refers to an assembly in which a plurality of battery cells is electrically connected.

A battery rack refers to a system of a single structure which is assembled by connecting module units set by a battery manufacturer in series/parallel and may be monitored and controlled by a battery management apparatus/system (BMS). A battery rack may include several battery modules (or battery packs) and a battery protection unit or any other protection device.

A battery bank refers to a group of large-scale battery rack systems configured by connecting a plurality of battery racks in parallel. A bank BMS for a battery bank may monitor and control several rack BMSs, each of which manages a battery rack.

A battery assembly may include a plurality of electrically connected battery cells, and refers to an assembly that functions as a power supply source by being applied to a specific system or device. Here, the battery assembly may mean a battery module, a battery pack, a battery rack, or a battery bank, but the scope of the present invention is not limited to these entities.

State of Charge (SOC) refers to a current state of charge of a battery, represented in percent points [%], and State of Health (SOH) may be a current condition of a battery compared to its ideal or original conditions, represented in percent points [%].

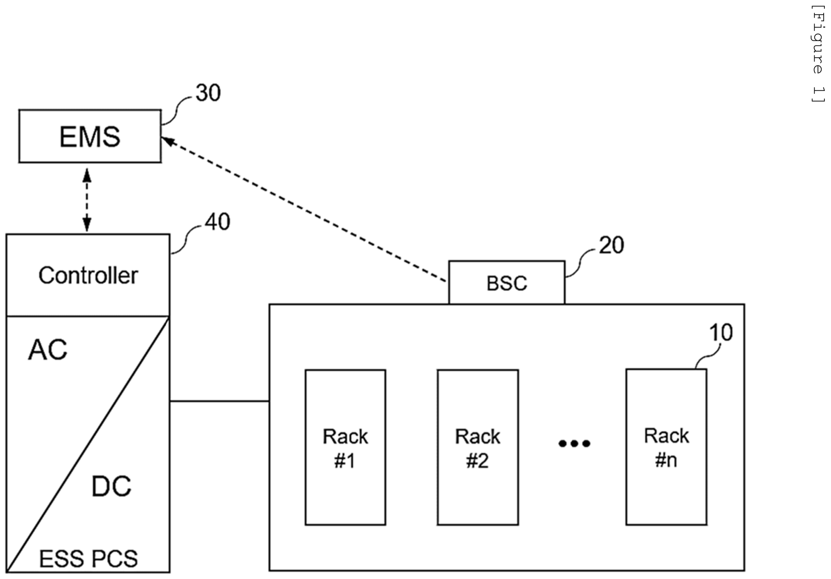

FIG. 1 is a block diagram of a general energy storage system.

In an energy storage system (ESS),a basic unit of battery for storing energy or power is a battery cell. Typically, a series/parallel combination of battery cells may form a battery module and multiple battery module may form a battery rack. In other words, a battery rack as a series/parallel combination of battery modules may be a basic unit of a battery system. Here, a battery module may be referred to as a battery pack depending on a device or a system in which the battery is used.

Referring to FIG.1, a battery rack 10 may include multiple battery modules and a battery protection unit or any other protection device. A battery rack may be monitored and controlled through a rack battery management system (rack BMS). The RBMS may monitor a current, a voltage and a temperature of each battery rack to be managed, calculate a state of charge (SOC) of the battery based on a monitoring result, and control charging and discharging.

Meanwhile, the battery protection unit (BPU) is a device for protecting the battery from abnormal current and fault current in a battery rack. The BPU may include a main contactor (MC), a fuse, a circuit breaker (CB), or a disconnect switch (DS). Here, the main contactor may include a positive main contactor and a negative main contactor. The BPU may control the battery system rack by rack by controlling the main contactor on/off according to control of the RBMS. The BPU may also protect the battery from short-circuit current by using a fuse when a short-circuit occurs. As such, a general battery system may be controlled through a protection device such as a BPU or a switch gear.

Meanwhile, a battery system controller (BSC) 20 may be located in each battery section which includes a plurality of batteries, peripheral circuits, and devices, so as to monitor and control objects such as a voltage, a current, a temperature, and a circuit breaker. The battery system controller may be a top-level controller of a bank-level battery system including a plurality of battery racks and is also used as a controller in a battery system with a multiple bank-level structure.

Furthermore, a power conversion system (PCS) 40 installed in each battery section may perform actual charging/discharging based on a charge/discharge command from an energy management system (EMS) 30. The power conversion system may include a power conversion unit (DC/AC inverter) and a controller. Meanwhile, the output of each BPU may be connected to a power generation device (e.g., photovoltaic system) and the PCS 40 which is connected to a power grid, through a DC link (or DC bus). In addition, the energy management system (EMS) 30 or a power management system (PMS) may control the energy storage system in overall.

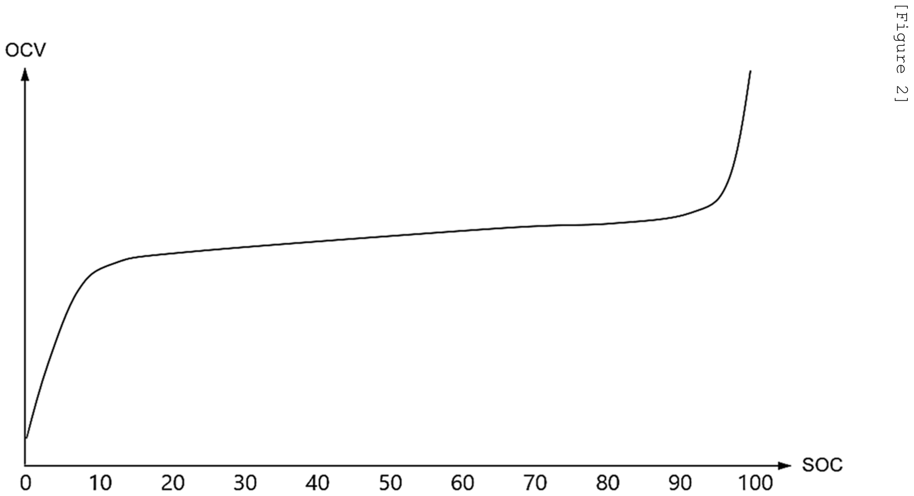

FIG. 2 shows a charge characteristic curve of an LFP battery.

More specifically, FIG. 2 shows a charge characteristic curve of a lithium iron phosphate (LFP) battery in which lithium iron phosphate is used as a cathode active material. The charge characteristic curve represents a correspondence between an open circuit voltage (OCV) and a SOC measured during a battery charge process.

In general, a battery control apparatus control batteries by using a charge characteristic curve of the battery. For example, the battery control apparatus may measure open circuit voltage values of the batteries, estimate SOCs of the batteries based on the charge characteristic curve of the battery, and perform balancing between the batteries or control parallel connection between the batteries based on the estimated SOCs.

Referring to FIG. 2, the charge characteristic curve of the LFP battery has a voltage plateau in a SOC range of about 10% to about 90%. In the case of the LFP battery having such a plateau characteristic, it is difficult to accurately estimate the SOC in the plateau section, so accurate estimation is possible only in non-plateau sections (e.g., sections where SOC is greater than 90%, or sections where SOC is less than 10%).

Accordingly, a battery system in which battery racks each including LFP battery cells are connected in parallel needs to periodically perform a process of charging battery racks to a voltage range where SOC estimation is possible and then correcting the SOC.

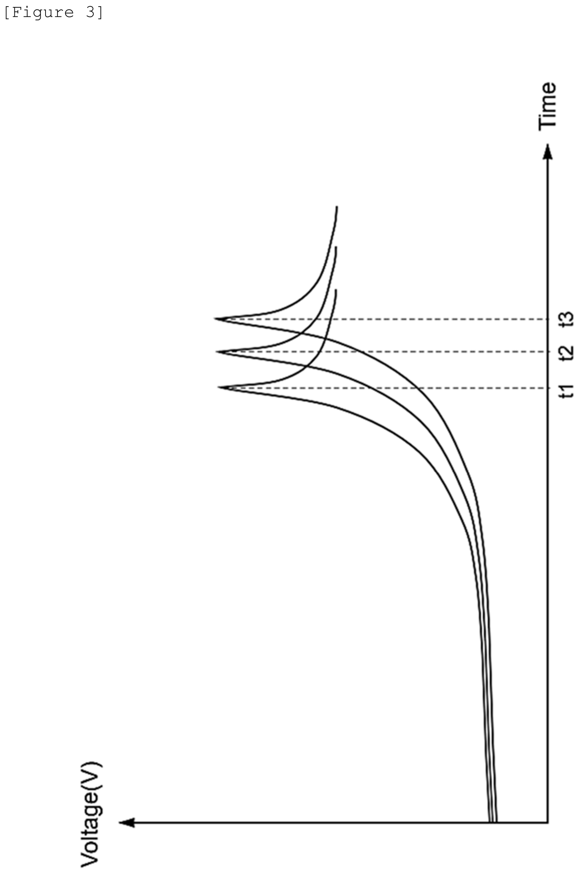

FIG. 3 is a graph for explaining a general battery control method.

In a battery system where one or more LFP batteries are applied, a battery control apparatus may process charging until a battery rack that has reached a predetermined high voltage section (for example, 3.6V) to correct SOC of the battery rack.

Here, the racks that have reached the high voltage section are sequentially removed from the direct current(DC link), and the battery control apparatus may correct the SOC of each rack if all the racks are removed from the DC link. When the SOC correction of all the racks is completed, all the racks are simultaneously connected to the DC link and connected in parallel with each other.

However, when the battery racks become connected in parallel to the DC link again after this SOC correction process is completed, an inrush current may occur in the battery system due to the characteristics of the LFP battery, in which the voltage rapidly increases or decreases in a non-plateau section (for example, a section where the SOC is 90% or higher, or a section where the SOC is 10% or lower).

For example, as shown in FIG. 3, if Rack #1 reaches a target voltage at time t1 and is removed from the DC link, then Rack #2 reaches the target voltage at time t2 and is removed from the DC link, and then Rack #3 reaches the target voltage at time t3 and is removed from the DC link, a high voltage difference occurs between Rack #1, which is removed from the DC link first, and Rack #3, which is removed from the DC link last. After the SOC correction process is completed, when Racks #1 to #3 are connected to the DC link at the same time, a high inrush current may flow momentarily toward Rack #1 due to this high voltage difference.

The present invention has been presented to solve this problem, and relates to a battery control apparatus and method for preventing inrush current from occurring in a battery system.

Hereinafter, embodiments of the present invention will be described in detail with reference to the accompanying drawings.

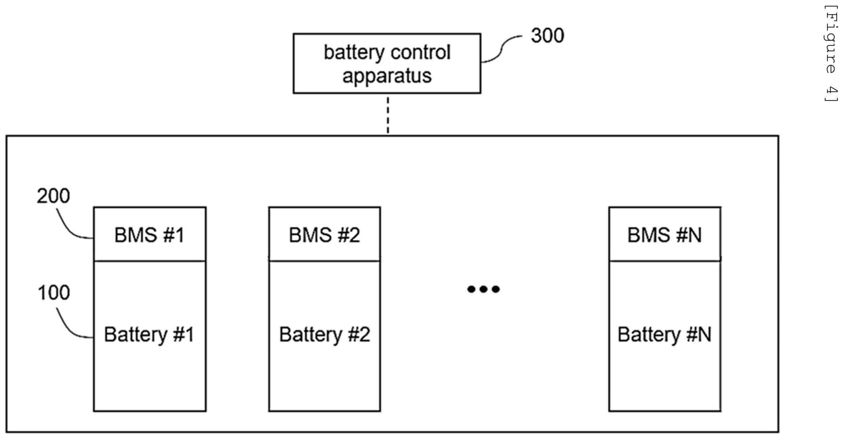

FIG. 4 is a block diagram of a battery system according to embodiments of the present invention.

Referring to FIG. 4, a battery system according to embodiments of the present invention may include a plurality of batteries 100, a plurality of battery management apparatuses 200 that are provided corresponding to each of the plurality of batteries and manage and control the corresponding batteries, and a battery control apparatus 300 that is connected to and interoperate with the plurality of battery management apparatuses 200.

The battery 100 may be a battery assembly including a plurality of unit cells that are electrically connected to each other. For example, the battery 100 may mean a battery rack, but the scope of the present invention is not limited thereto. In other words, the battery 100 according to the present invention may correspond to a battery module, a battery pack, or a battery bank.

The batteries 100 may be configured to be connected in parallel with each other. Here, each of the batteries 100 may be electrically connected to a direct current (DC) link and connected in parallel with other batteries.

Each of the batteries 100 may include a switch arranged at an input/output terminal, and when the switch is switched from a closed state to an open state, the electrical connection with the DC link is cut off and the parallel connection with another battery may be released. In contrast, when the switch of the battery 100 is switched from an open state to a closed state, the battery 100 may be electrically connected to the DC link and may be connected in parallel with other batteries.

The battery management apparatus 200 may collect state information on a corresponding battery 100 and perform a predetermined control operation based on the collected state information, thereby managing and controlling the corresponding battery 100. Here, the state information may include at least one of the voltage value and SOC value of the battery, and the voltage value and SOC value of each of the unit cells included in the battery.

The battery management apparatus 200 may control the operation of the switch provided at the input/output terminal of the battery 100.

Each of the battery management apparatus 200 may be connected to the battery control apparatus 300 through a network, transmit battery state information to the battery control apparatus 300, and receive a control command from the battery control apparatus 300 to operate. Here, the battery management apparatus 200 may receive a switch control signal for controlling the operation of the switch from the battery control apparatus 300 and control on/off operation of the switch according to the switch control signal.

The battery control apparatus 300 may monitor and control the operation status of each of the battery management apparatuses200.

The battery control apparatus 300 may correspond to a Battery System Controller (BSC), an Energy Management System (EMS), or a Power Management System (PMS).

The battery control apparatus 300 may perform a defined control process corresponding to the operation mode of the battery system.

When the battery system operates in a charge mode, the battery control apparatus 300 may monitor the voltage of each battery while the batteries are connected in parallel to the DC link and charged, and sequentially disconnect the batteries that have reached a predetermined target voltage from the DC link. Here, when only a predetermined number N of batteries remain connected to the DC link, the battery control apparatus 300 may stop the charge process while the N batteries are connected to the DC link.

When the charge process is stopped, the battery control apparatus 300 may correct SOCs of the batteries disconnected from the DC link and the batteries connected to the DC link.

When the battery system switches from a charge mode to a standby mode, the battery control apparatus 300 may collectively reconnect the batteries disconnected from the DC link to the DC link when the SOC of the batteries connected to the DC link reaches a predetermined SOC.

When the battery system switches from a charge mode to a discharge mode, the battery control apparatus 300 may sequentially reconnect batteries, that are disconnected from the DC link and whose voltage difference to the batteries connected to the DC link be comes into a predetermined range, to the DC link, during the process of discharging batteries connected to the DC link.

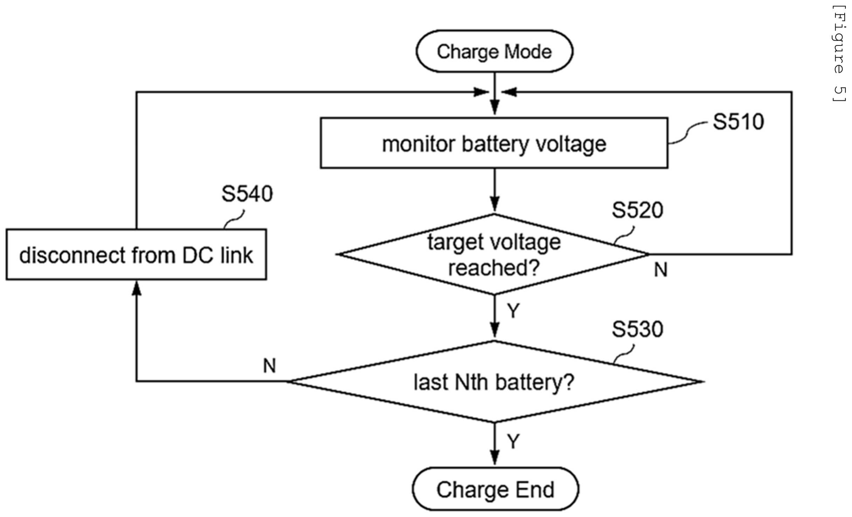

FIG. 5 is an operational flowchart of a battery control method in a charge mode according to embodiments of the present invention.

The battery control method according to embodiments of the present invention may be performed by a battery control apparatus located in a battery system including a plurality of batteries. Here, the battery control apparatus may correspond to an upper control apparatus that is connected and interoperates with the battery management apparatuses of each of the batteries, and may correspond to, for example, a Battery System Controller (BSC), an Energy Management System (EMS), or a Power Management System (PMS)that is connected and interoperates with a plurality of BMSs.

When the battery system operates in a charge mode, the battery control apparatus may monitor the voltage of each of the online batteries while the batteries connected in parallel to the DC link (online state) are being charged (S510).

Here, the battery control apparatus may receive the voltage of the battery or the voltage of each of the unit cells from a battery management device of each of the batteries.

The battery control apparatus may determine whether there is a battery among the batteries that has reached a predetermined target voltage (S520). Here, the target voltage may be predefined as a minimum voltage value that can estimate the SOC.

The battery control apparatus may determine that a corresponding battery has reached the target voltage when the maximum voltage value among voltage values of the unit cells included in a specific battery reaches the target voltage.

The battery control apparatus may sequentially remove one or more batteries that have reached the target voltage from the DC link until only a predetermined number of N batteries in the online state remain.

Specifically, when the voltage of a specific battery reaches the target voltage (Y of S520), the battery control apparatus may determine whether there exist N batteries currently in the online state (S530).

If there are more than N batteries currently in the online state (N of S530), the battery control apparatus may disconnect the corresponding battery from the DC link and switch it to an offline state (S540).

Here, the battery control apparatus may transmit a switch control signal that causes a switch connecting the battery and the DC link to be switched to an open state to a battery management apparatus of the battery that has reached the target voltage, thereby disconnecting the corresponding battery from the DC link.

If there are N batteries currently in the online state (Y of S530), the battery control apparatus may stop the charge process while the online batteries including the corresponding battery are being connected to the DC link.

In other words, the battery control apparatus may switch the online batteries connected to the DC link to an offline state in the order in which the online batteries reach the target voltage, and stop the charge process when only the predefined N online batteries remain.

In an embodiment, N may be defined as 1. Here, when only one online battery remains, the battery control apparatus may stop the charge process while the last online battery is being connected to the DC link, if the last online battery reaches the target voltage.

The purpose of keeping the last battery reaching the target voltage as online is to reduce the voltage faster than the batteries that have been switched to offline states.

When the charge process is stopped, the battery control apparatus may correct the SOCs of each of the offline battery and the N online batteries.

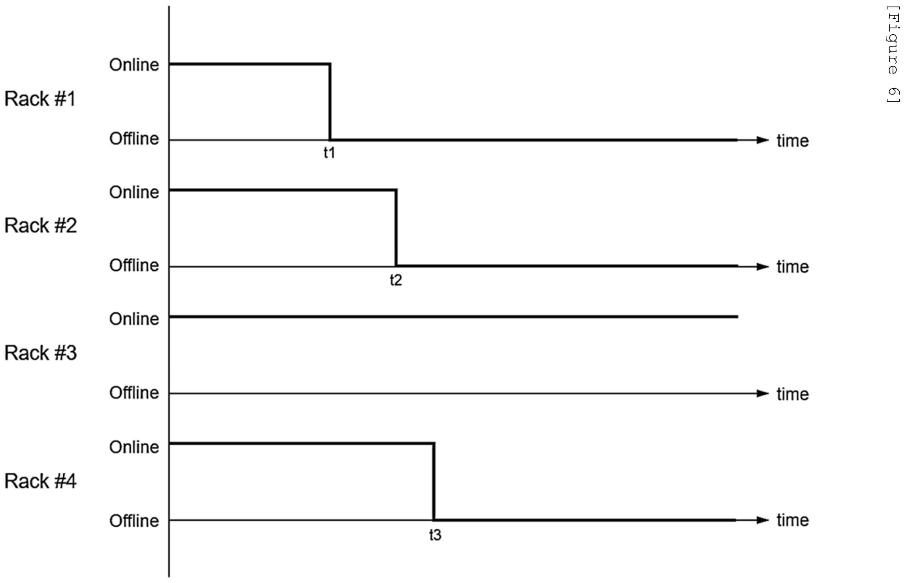

FIGS. 6 is a reference diagram for explaining a battery control method in a charge mode according to embodiments of the present invention. Hereinafter, with reference to FIG. 6, a battery control method in a charge mode according to embodiments of the present invention will be explained using a battery system including four battery racks connected in parallel as an example.

The battery control apparatus may monitor voltage of each of the racks (Rack #1 to #4) during a charge process of the racks in online state.

If the maximum voltage value (hereinafter, maximum cell voltage value) among the voltage values of the unit cells included in Rack #1 at time t1 reaches a target voltage (e.g., 3.6 V), the battery control apparatus may disconnect Rack #1 from the DC link at time t1 and switch it to an offline state.

Thereafter, if the maximum voltage value of Rack #2 reaches the target voltage at time t2, the battery control apparatus may disconnect Rack #2 from the DC link at time t2 and switch it to an offline state.

Afterwards, if the maximum voltage value of Rack #4 reaches the target voltage at time t3, the battery control apparatus may switch Rack #4 to an offline state by disconnecting Rack #4 from the DC link at time t3.

Thereafter, if the maximum voltage value of Rack #3 reaches the target voltage, the battery control apparatus may stop the charge process in a state that Rack #3 is connected to the DC link without switching Rack #3 to an offline state.

When the charge process is stopped, the battery control apparatus may update the SOC of each of the racks (Rack #1 to #4) based on the voltage value of each of the racks (Rack #1 to #4).

Meanwhile, when the charge process is stopped, the voltage of Rack #3, which is in an online state, decreases faster than the voltages of Rack #1, Rack #2, and Rack #4, which were previously switched to an offline state.

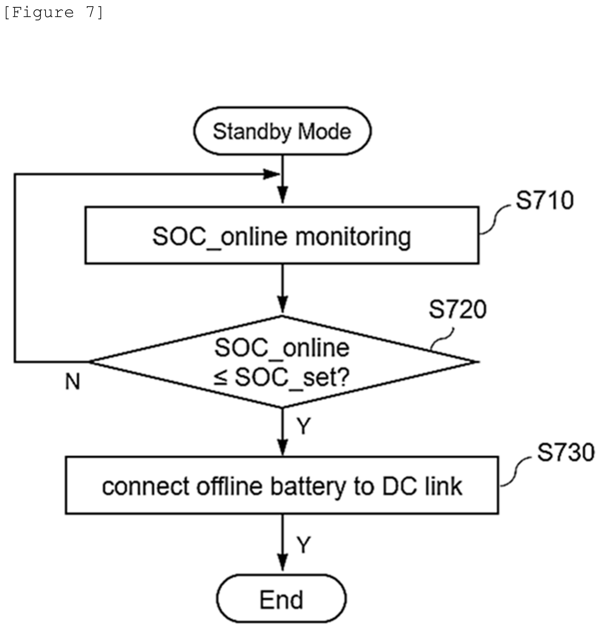

FIG. 7 is an operational flowchart of a battery control method in a standby mode according to embodiments of the present invention.

When the battery system is switched to a standby mode after the charge process in the charge mode is stopped, the battery control apparatus may monitor SOC of each of the N online batteries (S710).

Here, the battery control apparatus may receive an SOC value of the online battery from the battery management device of the online battery.

The battery control apparatus may determine whether the SOC of the online battery reaches a predetermined SOC (S720).

If the SOC of the online battery reaches the predetermined SOC (Y of S720), the battery control apparatus may collectively reconnect the offline batteries to the DC link and switch them to an online state (S730). Here, the set value of the SOC (SOC_set) may be defined as an SOC value at the time when the online battery is stabilized. If there are multiple online batteries (N is 2 or more), the battery control apparatus may collectively switch the offline batteries to the online state when the SOC of all the online batteries reaches the predetermined SOC.

In other words, when the battery system switches from a charge mode to a standby mode, the battery control apparatus may prevent occurrence of inrush current due to voltage difference by controlling all the batteries to be in parallel at the point when the voltage of the online battery is stabilized after a sharp decrease.

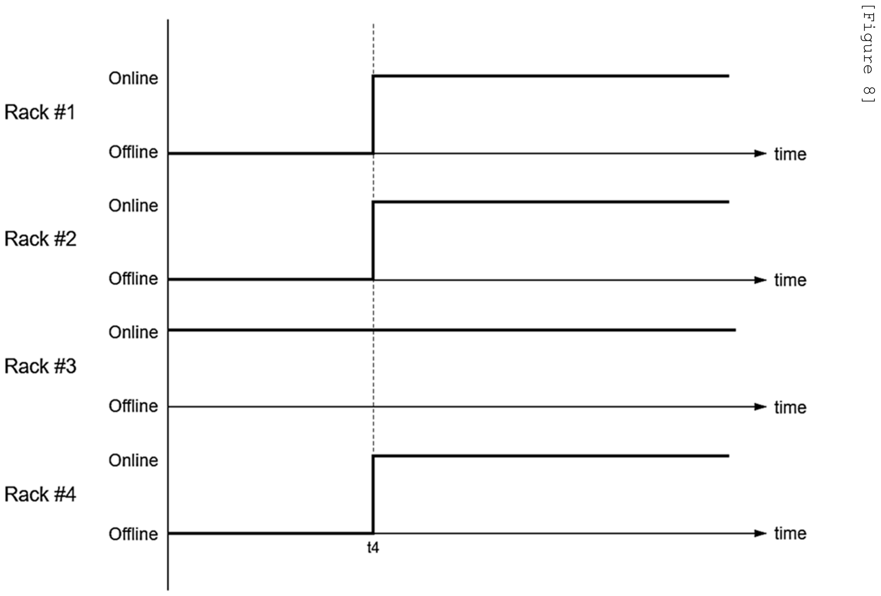

FIG. 8 is a reference diagram for explaining a battery control method in a standby mode according to embodiments of the present invention.

Hereinafter, with reference to FIG. 8, a battery control method in a standby mode, with a battery system including four battery racks connected in parallel as an example, according to embodiments of the present invention will be described.

When the battery system switches to a standby mode after the charge process in the charge mode is stopped, the battery control apparatus may monitor the SOC of Rack #3 which is an online rack.

When the SOC of Rack #3 gradually decreases and reaches a predetermined SOC at time t4, the battery control apparatus may collectively switch Rack #1, Rack #2, and Rack #4, which are in an offline state, to an online state at time t4.

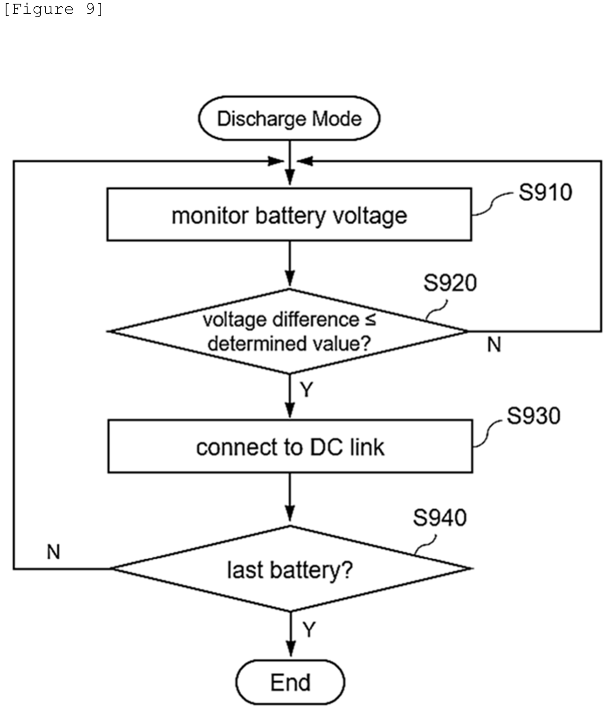

FIG. 9 is an operational flowchart of a battery control method in a discharge mode according to embodiments of the present invention.

When the battery system is switched to a discharge mode after the charge process in the charge mode is stopped, the battery control apparatus may monitor the voltage of each of the online battery and the offline battery during a process of discharging the online battery (S910).

The battery control apparatus may determine whether there is a battery, among the offline batteries, whose voltage difference with the online battery falls into a predetermined range (S920).

Here, the battery control apparatus may calculate voltage difference between the offline battery and the online battery based on an average cell voltage of the offline batteries and an average cell voltage of the online batteries.

The battery control apparatus may sequentially reconnect the offline battery whose voltage difference with the online battery falls within a predetermined range to the DC link.

Specifically, when the voltage difference between a specific offline battery and the online battery becomes equal to or less than a predetermined value (Y in S920), the battery control apparatus may reconnect the offline battery to the DC link and switch the offline battery to an online state (S930).

Here, the battery control apparatus may transmit a switch control signal for causing a switch connecting the battery and the DC link to be switched to a closed state to a battery management apparatus of the corresponding offline battery, so that the corresponding offline battery may be reconnected to the DC link.

Thereafter, the battery control apparatus may check whether the battery switched to the online state is the last battery (S940), and may perform steps S910 to S930 until all offline batteries are switched to an online state, if it is not the last battery (N of S940) .

In other words, when the battery system is switched from a charge mode to a discharge mode, the battery control apparatus may control the offline battery to be individually connected to the DC link at a point in time when the voltage of the offline battery approaches the voltage of the online battery, thereby preventing inrush current from being generated due to voltage difference.

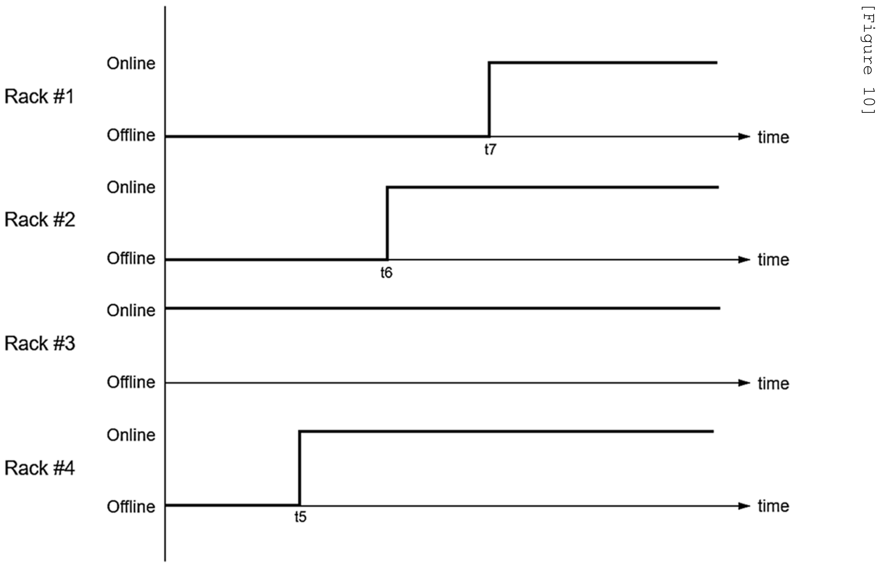

FIG. 10 is a reference diagram for explaining a battery control method in a discharge mode according to embodiments of the present invention.

Hereinafter, referring to FIG. 10, a battery control method in a discharge mode according to embodiments of the present invention will be explained using a battery system including four battery racks connected in parallel as an example.

The battery control apparatus may monitor the voltage of each of the racks (Rack #1 to #4) while Rack #3,in an online state, is being discharged.

When the voltage of Rack #3 in an online state gradually decreases and reaches the voltage of Rack #4 at time t5, the battery control apparatus may switch Rack #4 in the offline state to an online state at time t5.

Afterwards, when the voltages of Rack #3 and Rack #4 in the online state gradually decrease and reach the voltage of Rack #2 at time t6, the battery control apparatus may switch Rack #2 in an offline state to the online state at time t6.

Afterwards, when the voltages of Rack #2, Rack #3, and Rack #4 in the online state gradually decrease and reach the voltage of Rack #1 at time t7, the battery control apparatus may switch Rack #1 in the offline state to the online state at time t7.

Afterwards, all racks (Rack #1 to #4) may be discharged while being connected in parallel to the DC link.

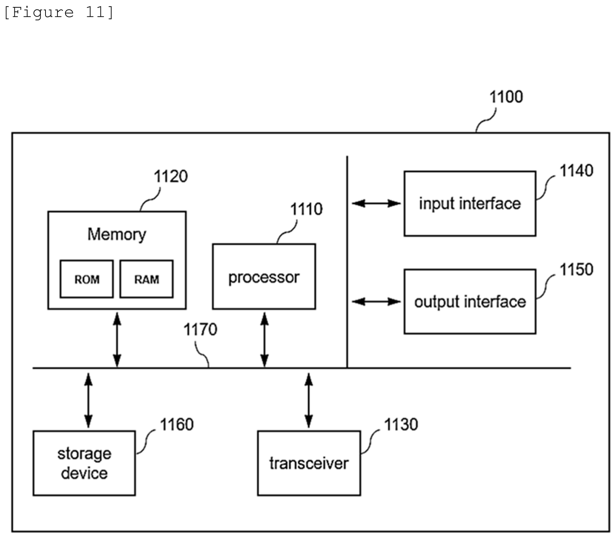

FIG. 11 is a block diagram of a battery control apparatus according to embodiments of the present invention.

The battery control apparatus 1100 according to embodiments of the present invention may be located in a battery system and linked with a battery management apparatus of each battery. For example, the battery control apparatus 1100 may correspond to a Battery System Controller (BSC), an Energy Management System (EMS), or a Power Management System (PMS), or may be implemented by being included in any one of them.

The battery control apparatus 1100 may include at least one processor 1110, a memory 1120 that stores at least one instruction executed by the processor, and a transceiver 1130 that is connected to a network and performs communication.

Here, the at least one instruction may include an instruction to monitor a voltage of each of the batteries while the batteries are connected in parallel to a direct current (DC) link and being charged; an instruction to sequentially disconnect at least one battery that has reached a predefined target voltage from the DC link; and an instruction to, if only a predetermined number N of batteries remain connected to the DC link, stop charge process in a state that the N batteries are connected to the DC link.

The instruction to monitor the voltage of each of the batteries may include an instruction to determine whether the maximum voltage value among voltage values of unit cells included in the battery reaches the target voltage.

The instruction to sequentially disconnect the at least one battery that have reached the predefined target voltage from the DC link may include an instruction to transmit a switch control signal for causing a switch connecting a battery and the DC link to be switched to an open state to a battery management apparatus of the at least one battery that has reached the predefined target voltage.

The instruction to stop the charge process may include an instruction to, when only one battery remains connected to the DC link and the last battery reaches the target voltage, stop the charge process in a state that the last battery is connected to the DC link.

The at least one instruction may further include an instruction to correct state of charges (SOCs) of one or more batteries disconnected from the DC link and one or more batteries connected to the DC link after the charge process is stopped.

The at least one instruction may further include an instruction to, upon the battery system switched to a standby mode after the charge process is stopped, collectively reconnect one or more batteries that have been disconnected from the DC link to the DC link when the SOC of the batteries connected to the DC link reaches a predetermined SOC.

The at least one instruction may further include an instruction to, upon the battery system switched to a discharge mode after the charge process is stopped, sequentially reconnect at least one battery, to the DC link, of which the voltage difference to at least one battery connected to the DC link becomes within a predetermined range in a process during which the at least one battery connected to the DC link is being discharged, among batteries that have been disconnected from the DC link.

The battery control apparatus 1100 according to embodiments of the present invention may further include an input interface device 1140, an output interface device 1150, a storage device 1160, etc. Respective components included in the battery control apparatus 1100 may be connected by a bus 1170 and can communicate with each other.

Here, the processor 1110 may mean a central processing unit (CPU), a graphics processing unit (GPU), or a dedicated processor on which methods according to embodiments of the present invention are performed. The memory (or storage unit) may include at least one of a volatile storage medium and a nonvolatile storage medium. For example, the memory may include at least one of read only memory (ROM) and random access memory (RAM).

The operations of the method according to the embodiments of the present invention may be implemented as a computer-readable program or code on a computer-readable recording medium. The computer-readable recording medium includes all types of recording devices in which data readable by a computer system is stored. In addition, the computer-readable recording medium may be distributed in a network-connected computer system to store and execute computer-readable programs or codes in a distributed manner.

Although some aspects of the invention have been described in the context of the apparatus, it may also represent a description according to a corresponding method, wherein a block or apparatus corresponds to a method step or feature of a method step. Similarly, aspects described in the context of a method may also represent a feature of a corresponding block or item or a corresponding apparatus. Some or all of the method steps may be performed by (or using) a hardware device, such as, for example, a microprocessor, a programmable computer, or an electronic circuit. In some embodiments, one or more of the most important method steps may be performed by such an apparatus.

In the forgoing, the present invention has been described with reference to embodiments of the present invention, but those skilled in the art may appreciate that the present invention may be variously corrected and changed within the range without departing from the spirit and the area of the present invention described in the appending claims.

## Claims

1. A battery control apparatus located in a battery system including a plurality of batteries, the apparatus comprising:
at least one processor; and
a memory configured to store at least one instruction executed by the at least one processor,
wherein the at least one instruction includes:
an instruction to monitor a voltage of each of the batteries while the batteries are connected in parallel to a direct current (DC) link and are being charged;
an instruction to sequentially disconnect at least one battery that has reached a predefined target voltage from the DC link; and
an instruction to, if only a predetermined number of batteries remain connected to the DC link, stop a charge process in a state that the predetermined number of batteries are connected to the DC link.

2. The apparatus of claim 1, wherein the instruction to monitor the voltage of each of the batteries includes:
an instruction to determine whether a maximum voltage value among voltage values of unit cells included in a battery reaches the target voltage.

3. The apparatus of claim 1, wherein the instruction to sequentially disconnect the at least one battery that has reached the predefined target voltage from the DC link includes:
an instruction to transmit a switch control signal for causing a switch connecting a battery and the DC link to be switched to an open state to a battery management apparatus of the at least one battery that has reached the predefined target voltage.

4. The apparatus of claim 1, wherein the instruction to stop the charge process includes:
an instruction to, when only one battery remains connected to the DC link and the one battery reaches the target voltage, stop the charge process in a state that the one battery is connected to the DC link.

5. The apparatus of claim 1, wherein the at least one instruction further includes:
an instruction to correct state of charges (SOCs) of one or more batteries disconnected from the DC link and one or more batteries connected to the DC link after the charge process is stopped.

6. The apparatus of claim 1, wherein the at least one instruction further includes:
an instruction to, upon the battery system switching to a standby mode after the charge process is stopped, collectively reconnecting one or more batteries that have been disconnected from the DC link to the DC link when a state of charge (SOC) of the batteries connected to the DC link reaches a predetermined SOC.

7. The apparatus of claim 1, wherein the at least one instruction further includes:
an instruction to, upon the battery system switching to a discharge mode after the charge process is stopped, sequentially reconnecting the at least one battery, to the DC link, of which a voltage difference to at least one battery connected to the DC link becomes within a predetermined range in a process during which the at least one battery connected to the DC link is being discharged, among batteries that have been disconnected from the DC link.

8. A battery control method performed by battery control apparatus located in a battery system including a plurality of batteries, the method comprising:
monitoring a voltage of each of the batteries while the batteries are connected in parallel to a direct current (DC) link and are being charged;
sequentially disconnecting at least one battery that has reached a predefined target voltage from the DC link; and
if only a predetermined number of batteries remain connected to the DC link, stopping a charge process in a state that the predetermined number of batteries are connected to the DC link.

9. The method of claim 8, wherein the monitoring the voltage of each of the batteries includes:
determining whether a maximum voltage value among voltage values of unit cells included in a battery reaches the target voltage.

10. The method of claim 8, wherein the sequentially disconnecting the at least one battery that has reached the predefined target voltage from the DC link includes:
transmitting a switch control signal for causing a switch connecting a battery and the DC link to be switched to an open state to a battery management apparatus of the at least one battery that has reached the predefined target voltage.

11. The method of claim 8, wherein the stopping the charge process includes:
when only one battery remains connected to the DC link and the one battery reaches the target voltage, stopping the charge process in a state that the one battery is connected to the DC link.

12. The method of claim 8, further comprising:
correcting state of charges (SOCs) of one or more batteries disconnected from the DC link and one or more batteries connected to the DC link after the charge process is stopped.

13. The method of claim 8, further comprising:
upon the battery system switching to a standby mode after the charge process is stopped, collectively reconnecting one or more batteries that have been disconnected from the DC link to the DC link when the state of charge (SOC) of the batteries connected to the DC link reaches a predetermined SOC.

14. The method of claim 8, further comprising:
upon the battery system switching to a discharge mode after the charge process is stopped, sequentially reconnecting the at least one battery, to the DC link, of which a voltage difference to at least one battery connected to the DC link becomes within a predetermined range in a process during which the at least one battery connected to the DC link is being discharged, among batteries that have been disconnected from the DC link.
